(19) Europäisches Patentamt
European Patent Office
Office européen des brevets

(11) **EP 4 707 823 A1**

(12) **EUROPEAN PATENT APPLICATION**

(43) Date of publication:
**11.03.2026 Bulletin 2026/11**

(21) Application number: **24198454.1**

(22) Date of filing: **04.09.2024**

(51) International Patent Classification (IPC):
**G01R 27/02** $^{(2006.01)}$    **G01R 31/52** $^{(2020.01)}$

(52) Cooperative Patent Classification (CPC):
**G01R 31/52; G01R 27/025;** G01R 31/006

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **VOLVO TRUCK CORPORATION**
**405 08 Göteborg (SE)**

(72) Inventors:
• **NEILSON, Rohan**
**721 31 VÄSTERÅS (SE)**
• **BARKAH, Dani**
**632 24 ESKILSTUNA (SE)**

(74) Representative: **Ström & Gulliksson AB**
**P.O. Box 4188**
**203 13 Malmö (SE)**

(54) **COMPUTER SYSTEM AND COMPUTER-IMPLEMENTED METHOD FOR DETERMINING A FAULTY GROUND CONNECTION**

(57)    A computer system is provided. The computer system comprises processing circuitry configured to: obtain first isolation resistance data (222) between a traction voltage pole (16A, 16B) and a chassis (P) of a vehicle (1) when at least one vehicle subsystem (10) is electrically disconnected from the traction voltage pole (16A, 16B); electrically connect the at least one vehicle subsystem (10) to the traction voltage pole (16A, 16B); obtain second isolation resistance data (224) between the traction voltage pole (16A, 16B) and the chassis (P) when the at least one vehicle subsystem (10) is electrically connected to the traction voltage pole (16A, 16B); compare the second isolation resistance data (224) with the first isolation resistance data (222); and determine a faulty ground connection of the at least one vehicle subsystem (10) based on the comparison of the second isolation resistance data (224) with the first isolation resistance data (222).

FIG. 8

EP 4 707 823 A1

## Description

### TECHNICAL FIELD

The disclosure relates generally to monitoring of electrical systems. In particular aspects, the disclosure relates to computer systems and computer-implemented method for determining a faulty ground connection. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Voltages in modern electrified vehicles present a significant hazard via the potential for exposing people to dangerous electrical currents. Ensuring this hazard will always be safely isolated and contained throughout a long life of the vehicle or during/after a collision is not practical and therefore isolation monitoring systems are employed to monitor the resistance to electrical leakage, thereby allowing systems to be shut down before or when a potential for dangerous current arises.

Isolation measurement systems are typically configured to monitor the resistance to electrical current leakage from the traction voltage poles to the vehicle chassis; usually from an entire voltage bus connecting multiple batteries, inverters etc. Where individual devices and/or sub-systems can be isolated from the main voltage bus their impact on the total value can be assessed but many cannot and this alone is not without limitations. Further, isolation of such devices and/or sub-systems may not be possible during operation of the associated vehicle.

Splitting the voltage bus into multiple floating buses can in some cases be an effective solution but requires multiple isolation resistance monitors along with many other replicated devices, and potentially even including expensive galvanically isolating DC/DC converters.

Fuel cell stacks, as well as immersion cooled battery systems, typically require liquid coolant and this coolant is exposed to significant voltages. Electrical conductivity through the coolant can carry potentially dangerous leakage currents, generally forcing the use of specialty low-conductivity coolants to increase the isolation resistance to the leakage currents. Additionally, ion-exchanging filters are typically required to remove ions which increase the electrical conductivity, and specialty materials and cleaning procedures to minimize the depletion of these filters.

Isolation monitoring systems, which measure the resistance to electrical current flow from the high voltage poles to the chassis, are typically employed but cannot directly determine the source of a fault.

In order for potential leakage current paths via components to be measured they need to be grounded. When a component loses its ground connection through a service error, fatigue, corrosion, collision etc., leakage currents will no longer flow via this path causing the resistance measured by the isolation monitoring system to show an improved condition despite a deterioration in actuality and potential hazard present. Additionally the voltage potential present at the component will generally increase.

Some components, typically passive, can be left floating (i.e. un-grounded) providing that they are known to possess a safely high isolation resistance; this would reduce the total leakage via the chassis/ground thereby improving safety. However, to safely ensure these components maintain this condition through life requires monitoring and therefore grounding.

In the case of electrical leakage through cooling system, conductivity sensors can provide a measure of the electrical conductivity of the coolant at a specific temperature, but this may not be an accurate measure of the cooling systems contribution to the total isolation resistance. Coolant hoses can provide a significantly low electrical resistance and may be subject to production variance, service negligence, internal contamination such as salt bridges, external build-up of contaminants or accidental grounding, etc.

In view of above, there is a need for improvement for detecting a faulty or missing ground connection.

### SUMMARY

According to a first aspect of the disclosure, a computer system is provided. The computer system comprises processing circuitry configured to obtain first isolation resistance data between a traction voltage pole and a chassis of a vehicle when at least one vehicle subsystem is electrically disconnected from the traction voltage pole, to electrically connect the at least one vehicle subsystem to the traction voltage pole, and to obtain second isolation resistance data between the traction voltage pole and the chassis when the at least one vehicle subsystem is electrically connected to the traction voltage pole. The processing circuitry is further configured to compare the second isolation resistance data with the first isolation resistance data, and to determine a faulty ground connection of the at least one vehicle subsystem based on the comparison of the second isolation resistance data with the first isolation resistance data. The first aspect may seek to reduce the risk for false indications of high isolation resistance, as a faulty ground connection will stop leakage current to flow in the affected path. Without the proposed solution, such situation will indicate an improved isolation resistance. A technical benefit may include robust and simple handling of the potential hazard of leakage currents.

In the simplest case the vehicle subsystem has a maximum expected isolation resistance and a check is made that the second isolation resistance data is below this value. In some cases this expected value could come from installed bleed or discharge resistors. In the case of an immersion cooled battery or a fuel cell system it is typically dictated by the dielectric coolant conductivity and physical dimensions. In some cases the expected value could be an actual measurement from the subsystem before, after or in some cases even while it is connected (depending on the measurement). If possible the voltage bus and/or isolation resistance monitoring device is connected to this subsystem to directly measure the isolation resistance to ensure it is below what would be an unrealistic value (a value above would indicate a ground fault). Since this is not normally feasible and may be entering a region of low isolation resistance monitor accuracy the subsystem is checked by comparison. When the subsystem is connected the isolation resistance should drop from the first total value to a second total value which is below or equal to that expected from adding the maximum expected subsystem value in parallel to the first measurement. Equivalently the subsystems indicated value can be calculated from the drop from first to second total value and compared to the expected value. The characteristics of the isolation resistance monitoring device such as accuracy and resolution are also factored into acceptance criteria. If the values are out of acceptance where the isolation resistance monitoring device can be expected to positively detect this then a ground fault is indicated. Similarly the capacitance is another indicator which can be handled in essentially the same way in that the subsystem should not contribute more or less than expected amounts or distribution of capacitance otherwise it is indicated to be floating with the voltage bus instead of being coupled to the chassis.

Optionally in some examples, including in at least one preferred example, the processing circuitry is further configured to: obtain an isolation resistance difference between the first isolation resistance data and the second isolation resistance data, obtain a pre-determined reference difference, and compare the obtained isolation resistance difference with the pre-determined reference difference. A technical benefit may include a fast and robust comparison in order to determine if a ground connection is faulty or not.

Optionally in some examples, including in at least one preferred example, the processing circuitry is further configured to: obtain the pre-determined reference difference as a predetermined reference difference interval. A technical benefit may include an even more robust comparison, accepting tolerances in measurements.

Optionally in some examples, including in at least one preferred example, the processing circuitry is further configured to: determine a faulty ground connection of the at least one vehicle subsystem when the second isolation resistance data is less or greater than the first isolation resistance data. A technical benefit may include a simple comparison requiring no additional parameters or values in order to determine a faulty ground connection.

Optionally in some examples, including in at least one preferred example, the processing circuitry is further configured to: electrically short circuit a leakage path of the at least one vehicle subsystem, obtain third isolation resistance data between the traction voltage pole and the chassis when the leakage path of at least one vehicle subsystem is electrically short circuited, compare the third isolation resistance data with the second isolation resistance data, and determine a faulty ground connection of the at least one vehicle subsystem based on the comparison of the third isolation resistance data with the second isolation resistance data. A technical benefit may include a more sophisticated and reliable methodology for determining if a ground connection is faulty or not. Especially, by shorting a significant amount of resistance in a leakage path to a grounded component both the effectiveness of this resistance and the presence of a ground connection in this path can be checked. In other words, shorting sections distributed resistances should give a response confirming the presence of a functioning ground connection or having a characteristic behavior if faulty or partly faulty. Isolating paths or components within the subsystem should cause a shift if a functioning earth is in place. Adding temporary grounds parallel to the larger permanent conduits should not cause a response if the permanent ground is in place. Adding temporary shorts between normally grounded components should not cause a shift, and shorts between components should have a known characteristic.

Optionally in some examples, including in at least one preferred example, the processing circuitry is further configured to: obtain second isolation resistance data for each one of a plurality of temperatures of the at least one vehicle subsystem, and compare each one of the second isolation resistance data with the first isolation resistance data. A technical benefit may include more reliable detection of a faulty ground connection, especially in applications where temperature affects conductivity. Hence, some resistances have a predictable temperature dependence allowing the actual behavior to be assessed against a reduced dependence that may identify or characterize a missing ground connection.

Optionally in some examples, including in at least one preferred example, the processing circuitry is further configured to: obtain an isolation resistance difference between the first isolation resistance data and the second isolation resistance data, obtain a pre-determined reference difference interval, compare the obtained isolation resistance difference with the pre-determined reference difference interval, electrically short circuit a leakage path of the at least one vehicle subsystem, obtain third isolation resistance data between the traction voltage pole and the chassis for a plurality of temperatures when the leakage path of at least one vehicle subsystem is electrically short circuited, obtain an isolation resistance difference between each one of the third isolation resistance data and the second isolation resistance data, obtain a pre-determined reference difference interval, compare the obtained isolation resistance difference with the pre-determined reference difference interval, and determine a faulty ground connection of the at least one vehicle subsystem based on the comparison of the third isolation resistance data with the second isolation resistance data and/or based on the comparison of the second isolation resistance data with the first isolation resistance data.

According to a second aspect of the disclosure, a vehicle is provided. The vehicle comprises the computer system of the first aspect. The second aspect may seek to reduce the risk for false indications of high isolation resistance, as a faulty ground connection will stop leakage current to flow in the affected path. Without the proposed solution, such situation will indicate an improved isolation resistance. A technical benefit may include robust and simple handling of the potential hazard of leakage currents.

Optionally in some examples, including in at least one preferred example, the vehicle further comprises at least one fuel cell system and/or an immersion cooled battery system forming the vehicle subsystem. A technical benefit may include a simple yet robust solution for applications involving vehicle subsystems which implement electrically conducting coolants. These coolants are typically an imperfect non-conducting coolant or fluid.

Optionally in some examples, including in at least one preferred example, the at least one fuel cell system and/or immersion cooled battery system comprises at least one coolant channel connected to a radiator, and wherein the coolant forms a leakage path. A technical benefit may include improving safety and avoiding leakage currents in coolants.

Optionally in some examples, including in at least one preferred example, the vehicle further comprises a switch configured to short circuit a portion (or section) of the leakage path.

Optionally in some examples, including in at least one preferred example, the vehicle further comprises a valve configured to isolate one or more coolant paths.

Optionally in some examples, including in at least one preferred example, the vehicle further comprises switched test grounds or switched bridges between components of interest.

Optionally in some examples, the vehicle is configured to detect voltages or voltage disturbances at components or locations, the ability to confirm synchronization with disturbance of the main voltage bus.

Optionally in some examples the vehicle comprises a conductivity sensor allowing estimation of localized resistances, including in at least one preferred example, the vehicle further comprises temperature data for compensation. A technical benefit may include a reliable and simple modification to existing circuits in order to be able to determine if a ground connection is faulty or not.

According to a third aspect of the disclosure, a computer-implemented method is provided. The computer-implemented method comprises: obtaining, by processing circuitry of a computer system, first isolation resistance data between a traction voltage pole and a chassis of a vehicle when at least one vehicle subsystem is electrically disconnected from the traction voltage pole, electrically connecting, by the processing circuitry, the at least one vehicle subsystem to the traction voltage pole, obtaining, by the processing circuitry, second isolation resistance data between the traction voltage pole and the chassis when the at least one vehicle subsystem is electrically connected to the traction voltage pole, comparing, by the processing circuitry, the second isolation resistance data with the first isolation resistance data, and determining, by the processing circuitry, a faulty ground connection of the at least one vehicle subsystem based on the comparison of the second isolation resistance data with the first isolation resistance data. The third aspect may seek to reduce the risk for false indications of high isolation resistance, as a faulty ground connection will stop leakage current to flow in the affected path. Without the proposed solution, such situation will indicate an improved isolation resistance. A technical benefit may include robust and simple handling of the potential hazard of leakage currents.

Optionally in some examples, including in at least one preferred example, the method further comprises: obtaining, by the processing circuitry, an isolation resistance difference between the first isolation resistance data and the second isolation resistance data, obtaining, by the processing circuitry, a pre-determined reference difference, and comparing, by the processing circuitry, the obtained isolation resistance difference with the pre-determined reference difference. A technical benefit may include a fast and robust comparison in order to determine if a ground connection is faulty or not.

Optionally in some examples, including in at least one preferred example, the method further comprises obtaining, by the processing circuitry, the pre-determined reference difference as a predetermined reference difference interval. A technical benefit may include an even more robust comparison, accepting tolerances in measurements.

Optionally in some examples, including in at least one preferred example, the method further comprises determining, by the processing circuitry, a faulty ground connection of the at least one vehicle subsystem when the second isolation resistance data is greater the first isolation resistance data. A technical benefit may include a simple comparison requiring no additional parameters or values in order to determine a faulty ground connection. Analysis of a resistance shift can be performed as components or subsystems are added or removed in which case the resistance should drop or rise respectively. The resistance should still typically reduce slightly when a component with missing ground is added, but the reduction would not be as great as would normally be expected.

Optionally in some examples, including in at least one preferred example, the method further comprises electrically short circuiting, by the processing circuitry, a leakage path of the at least one vehicle subsystem, obtaining, by the processing circuitry, third isolation resistance data between the traction voltage pole and the chassis when the leakage path of at least one vehicle subsystem is electrically short circuited, comparing, by the processing circuitry, the third isolation resistance data with the second isolation resistance data, and determining, by the processing circuitry, a faulty ground connection of the at least one vehicle subsystem based on the comparison of the third isolation resistance data with the second isolation resistance data. This can also allow the check to be performed periodically while a subsystem is running, i.e. there is no need for opening the contactors and disconnecting the vehicle subsystem from the traction voltage bus. A technical benefit may include a more sophisticated and reliable methodology for determining if a ground connection is faulty or not. Especially, by shorting a significant amount of resistance in a leakage path to a grounded component both the effectiveness of this resistance and the presence of a ground connection in this path can be checked.

Optionally in some examples, including in at least one preferred example, the method further comprises obtaining, by the processing circuitry, second isolation resistance data for each one of a plurality of temperatures of the at least one vehicle subsystem, and comparing, by the processing circuitry, each one of the second isolation resistance data with the first isolation resistance data. A technical benefit may include more reliable detection of a faulty ground connection, especially in applications where temperature affects conductivity.

Optionally in some examples, including in at least one preferred example, the method further comprises obtaining, by the processing circuitry, third isolation resistance data for each one of a plurality of temperatures of the at least one vehicle subsystem, and comparing, by the processing circuitry, each one of the third isolation resistance data with the second isolation resistance data. A technical benefit may include an even more reliable detection of a faulty ground connection, especially in applications where temperature affects conductivity.

According to a fourth aspect of the disclosure, a computer program product is provided. The computer program product comprises program code for performing, when executed by the processing circuitry, the method of the third aspect. The fourth aspect may seek to reduce the risk for false indications of high isolation resistance, as a faulty ground connection will stop leakage current to flow in the affected path. Without the proposed solution, such situation will indicate an improved isolation resistance. A technical benefit may include robust and simple handling of the potential hazard of leakage currents.

According to a fifth aspect of the disclosure, a non-transitory computer-readable storage medium is provided. The non-transitory computer-readable storage medium comprises instructions, which when executed by the processing circuitry, cause the processing circuitry to perform the method of the third aspect. The fifth aspect may seek to reduce the risk for false indications of high isolation resistance, as a faulty ground connection will stop leakage current to flow in the affected path. Without the proposed solution, such situation will indicate an improved isolation resistance. A technical benefit may include robust and simple handling of the potential hazard of leakage currents.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

**BRIEF DESCRIPTION OF THE DRAWINGS**

Examples are described in more detail below with reference to the appended drawings.

**FIG. 1** is an exemplary side view of a vehicle according to an example.

**FIG. 2** is an exemplary electrical circuit of a fuel cell system according to an example.

**FIG. 3** is an exemplary system diagram of a ground fault detection system according to an example.

**FIG. 4** is an exemplary electrical circuit of a fuel cell system according to an example.

**FIG. 5A** is an exemplary electrical circuit of a different fuel cell system according to an examples.

**FIG. 5B** is an exemplary electrical circuit of a different fuel cell system according to an example.

**FIG. 5C** is an exemplary electrical circuit of a different fuel cell system according to an example.

**FIG. 5D** is a diagram showing voltage measurements from the fuel cell system shown in **FIG. 5C.**

**FIG. 6** is an exemplary system diagram of a ground fault detection system according to an example.

**FIGS. 7A-C** are schematic circuit diagrams illustrating a method for detecting a ground fault according to an example.

**FIGS. 8-11** are exemplary electrical circuit diagrams for fuel cell systems according to different examples.

FIG. 12 is a flow chart of a method of ground fault detection according to an example.

FIG. 13 is a schematic diagram of an exemplary computer system for implementing examples disclosed herein, according to an example.

## DETAILED DESCRIPTION

The detailed description set forth below provides information and examples of the disclosed technology with sufficient detail to enable those skilled in the art to practice the disclosure.

In the following various examples will be given all related to the general idea of ground fault detection between a traction voltage pole and a chassis. Isolation resistance data is obtained before and after connection of a vehicle subsystem to the traction voltage pole. By comparing these isolation resistance data, it is possible to determine if there is a faulty ground connection of the connected vehicle subsystem.

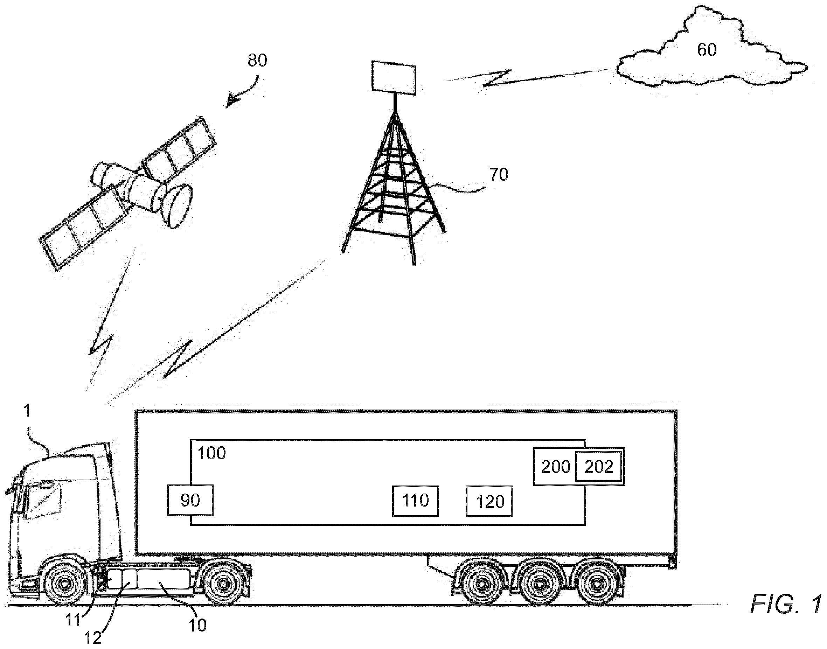

**FIG. 1** is an exemplary view of a vehicle **1** according to one example. The vehicle **1** comprises at least one ground fault detection system **200**. The at least one ground fault detection system **200** is configured to determine a faulty ground connection of one or more subsystems of the vehicle **1,** for example of a pump **11** or of a radiator **12** of one or more fuel cell systems or immersion cooled battery systems **10**. The vehicle **1** is programmed to control the ground fault detection system **200,** as will be described further in the following.

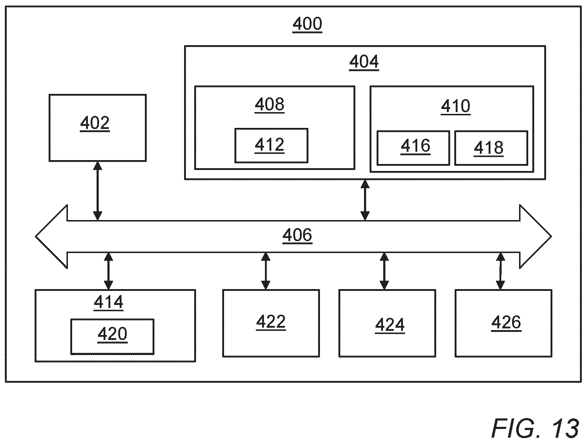

The vehicle **1** comprises, at least to some extent, processing circuitry **110** forming part of a computer system **100** (see **FIG. 13**). The processing circuitry **110** is configured to implement the ground fault detection system **200**.

The vehicle **1** may further comprise communications circuitry **90** configured to receive and/or send communications. The communications circuitry **90** may be configured to enable the vehicle **1** to communicate with one or more external devices or systems such as a cloud server **60.** The communication with the external devices or systems may be directly or via a communications interface such as a cellular communications interface **70,** such as a radio base station. The cloud server **60** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface may be a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The communication circuitry **90** may, additionally or alternatively, be configured to enable the vehicle **1** to be operatively connected to a Global Navigation Satellite System (GNSS) **80** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **1** may for example be configured to utilize data obtain from the GNSS **80** to determine a geographical location of the vehicle **1.**

The vehicle **1** in **FIG. 1** comprises the computer system **100** and the ground fault detection system **200**. The computer system **100** may be operatively connected to the ground fault detection system **200** and optionally to the communications circuitry **90** of the vehicle **1.** The computer system **100** comprises processing circuitry **110**. The computer system **100** may comprise a storage device **120,** advantageously a non-volatile storage device such as a hard disk drives (HDDs), solid-state drives (SSDs) etc. In some examples, the storage device **120** is operatively connected to the computer system **100**. The ground fault detection system **200** may comprise ground fault detection system processing circuitry **202;** the ground fault detection system processing circuitry **202** may be part of the processing circuitry **110** of the computer system **100**.

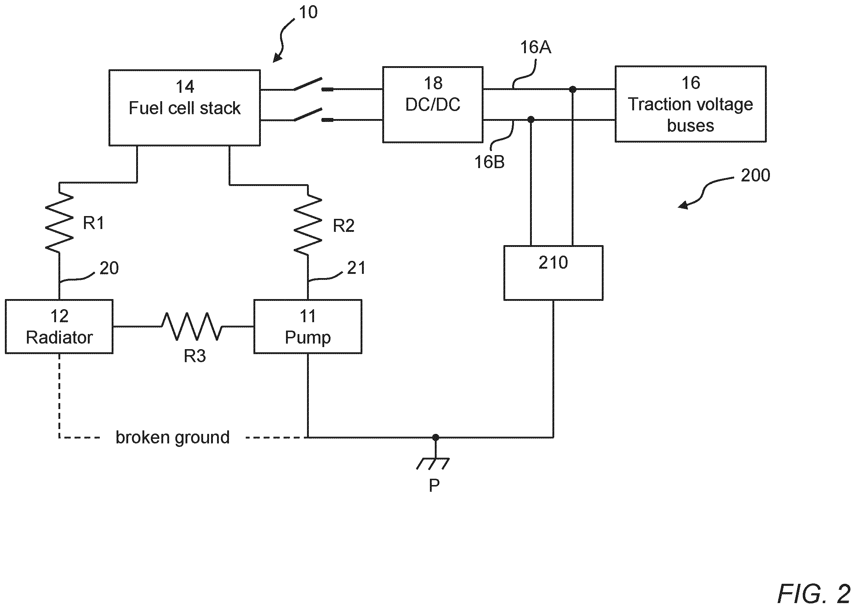

An example of a fuel cell system **10** is shown in **FIG. 2**. It should be noted that the reference numeral **10** may also indicate an immersion cooled battery system. The fuel cell system **10** is configured to be monitored by a ground fault detection system **200,** which in the shown example is at least partly embodied by an isolation resistance monitor device **210**.

The fuel cell system **10** comprises a fuel cell stack **14** which is connectable to traction voltage buses **16** via a DC/DC converter **18**. The isolation resistance monitoring device **210** is connected to the traction voltage buses **16** and is configured to measure the resistance across the fuel cell system **10**.

The fuel cell system **10** further comprises a pump **11** and a radiator **12**. The pump **11** and the radiator **12** are connected to the fuel cell stack **14** by liquid coolant conduits **20, 21**. Each one of the liquid coolant conduits **20, 21** may be represented by and electrical resistance **R1, R2**. The magnitude of these resistances **R1, R2** is dependent on the electrical conductivity of the coolant flowing inside the conduits **20, 21**. As the electrical conductivity through the coolant can carry potentially dangerous leakage currents, especially if the resistances **R1, R2** are low, the pump **11** and the radiator **12** are grounded. Hence, the leakage currents can be measured and monitored.

As shown in **FIG. 2,** the radiator **12** has lost its connection to ground **P** (indicated by the dashed line). When a component loses its ground connection through a service error, fatigue, corrosion, collision etc., leakage currents will no longer flow via this path causing the resistance measured by the isolation resistance monitoring device **210** to show an improved condition despite a deterioration in actuality and potential hazard present. Additionally the voltage potential present at the component will generally increase. Hence, missing ground connections can cause a false improvement in the measured isolation resistance since they stop leakage via the affected path causing it to appear to have a high resistance.

In **FIG. 2**, normally the total resistance $R_{tot}$ of the fuel cell system **10** can be determined by the following equation:

$$\frac{1}{R_{tot}} = \frac{1}{R_1} + \frac{1}{R_2}.$$

However, when the radiator **12** loses its connection to ground (indicated by the dashed line) the total resistance increases to:

$$\frac{1}{R_{tot}} = \frac{1}{R_1+R_3} + \frac{1}{R_2}.$$

If the un-grounded radiator **12** did not have the alternative path to ground as shown by resistance **R3**, the measured resistance would increase even more to $R_{tot} = R_2$.

This situation presents a potential hazard since the affected radiator **12** may now possess significant voltage potential against the chassis, however, the leakage path is now broken and so the measured isolation resistance for the vehicle actually improves indicating better than usual safety.

Where a low isolation resistance occurs and technicians begin tracing such a fault it is possible that a grounding connection may be broken or removed and not replaced or fixed during the remediation work. As shown above the isolation resistance measurement will actually improve when this mistake is made giving a false positive resolution. Even further, an unfamiliar or unsuitably trained technician may interpret this as though removing a ground strap "fixed" a problem in the system since the isolation may recover sufficiently to remove the fault condition and allow the machine to resume operations.

It may also be that a grounding fault occurs over time causing the measured isolation resistance of a machine to improve despite ongoing degradation of the coolant.

The ground fault detection system **200** shown in **FIG. 2** operates by measuring the total resistance $R_{tot}$ before and after the fuel cell system **10** is connected to the traction voltage buses **16**. Such connection may preferably be achieved by controlling the switchable connectors **30** from a disconnected state to a connected state. By analyzing the shift as the components are added their individual contributions can be inferred. Furthermore, by analyzing the change in isolation resistance as temperatures change the temperature dependence can be inferred and potentially separated. If the total **(R1,R3)∥R2** value falls outside of the expected range then detection is simple. If this is not the case ground fault detection is possible but complex and difficult/unreliable without other features such as another measurement of resistance or conductivity, a short or switch, or knowing the conductivity. In particular, with no other features shown but temperatures assumed to be measured then the detection would need to rely on a lower than expected response to inlet temperature changes coupled with higher than expected response to outlet temperature changes.

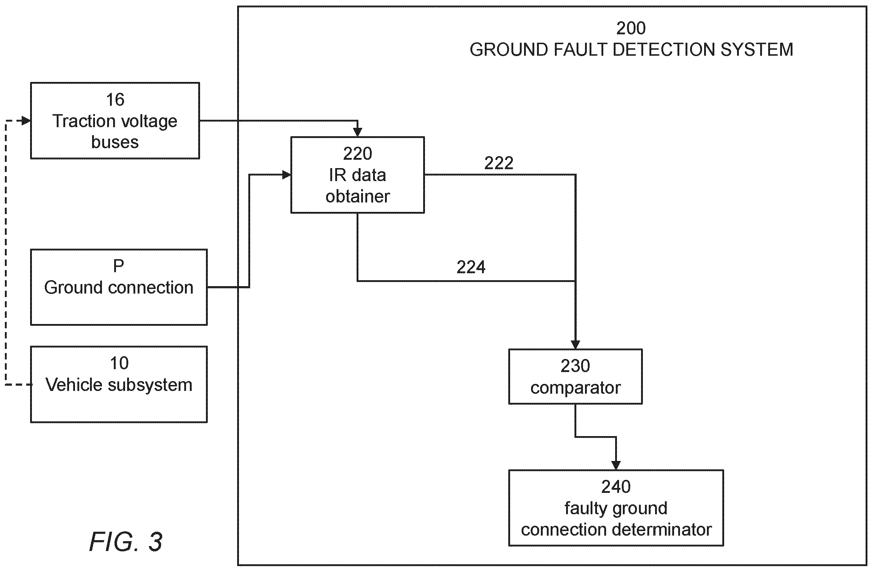

In particular, an example of a ground fault detection system **200** is shown in **FIG. 3**. The ground fault detection system **200** comprises an isolation resistance data obtainer **220**. The isolation resistance data obtainer **220** may be realized as an isolation resistance monitoring device **210** as illustrated in **FIG. 2**. The isolation resistance data obtainer **220** is configured to obtain first isolation resistance data **222** between a traction voltage pole **16A, 16B** of traction voltage buses **16** and a chassis **P** of a vehicle **1** when at least one vehicle subsystem, e.g. the fuel cell system **10,** is electrically disconnected from the traction voltage pole **16A, 16B**. When first isolation resistance data is obtained, the at least one vehicle subsystem **10** is electrically connected to the traction voltage pole **16A, 16B**.

The isolation resistance data obtainer **220** is further configured to obtain second isolation resistance data **224** between a traction voltage pole **16A, 16B** of traction voltage buses **16** and a chassis **P** of a vehicle **1** when at least one vehicle subsystem, e.g. the fuel cell system **10,** is electrically connected to the traction voltage pole **16A, 16B**.

The ground fault detection system **200** further comprises a comparator **230**. The comparator **230** is configured to compare the second isolation resistance data **224** with the first isolation resistance data **222**.

The ground fault detection system **200** further comprises a faulty ground connection determinator **240**. The faulty ground connection determinator **240** is configured to determine a faulty ground connection of the at least one vehicle subsystem **10** based on the comparison of the second isolation resistance data **224** with the first isolation resistance data 222.

As explained above with reference to **FIG. 2,** the total isolation resistance $R_{tot}$ will likely decrease when the vehicle subsystem **10,** i.e. the fuel cell system **10,** is electrically connected to the traction voltage buses **16**. Especially, and still with reference to the fuel cell system **10** of **FIG. 2,** when there is no faulty ground connection of the vehicle subsystem **10** the second isolation resistance data **224** will be significantly lower than the first isolation resistance data **222**. However, if a faulty ground connection does exist, as in the example shown in **FIG. 2,** the second isolation resistance data **224** will be higher although still lower than the first isolation resistance data **222**. Hence, by knowing an expected difference or ratio between the first and second isolation resistance data **222, 224** when all ground connections are perfect, it is possible to identify a missing or faulty ground connection simply based on a comparison between the first and second isolation resistance data **222, 224.**

In order to further improve ground fault detection it is suggested to create shifts in the value of $R_{tot}$ and to analyze those shifts. This can be achieve by dividing up or shorting resistance paths.

Shorts should be large enough to provide some accuracy (i.e. a significant change) but not so large so as to produce dangerous leakage currents or allow components to build significant voltages. The primary approach is to make use of an isolation measurement device already fitted and relies on performing software calculations based on the measurements taken by this device rather than introducing voltage, current or conductivity measurement devices to the system.

In some cases where a valve is present specific components may be isolated or able to isolate if they can do so safely so as to change the length of a leakage path without creating a danger. This may affect material choice and layout to provide a best optimization. Start up and shutdown routines may be tailored to exploit such approaches. Performing multiple calculations while the system warms up can help to generate data on the actual relationship between temperature and conductivity. Further, temporary temperature deviations may also be used to check such values while operating or to allow such calculation or compensation to be performed with simpler implementations.

It is thus preferable that the temperatures of analyzed volumes are available and mixing and other deviations avoided. Analysis of two significantly different temperatures can give good thermal coefficient data/-compensation but two similar temperature volumes can be easier for sensitivity analysis. Temporary complete coolant flow diversions may be used to isolate leakage paths for the purposes of making calculations possible. By shorting a significant amount of resistance in a leakage path to a grounded component both the effectiveness of this resistance and the presence of a grounding connection in this path can be checked as described in the following.

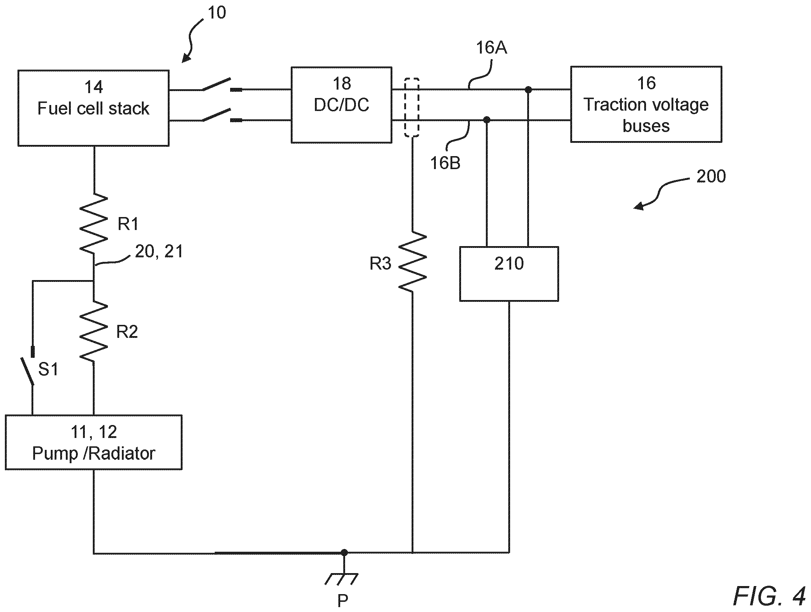

FIG. 4 shows a fuel cell system **10** according to one example. This example is a simplification, illustrating how the fuel cell coolant paths 20, 21 (represented by resistances **R1, R2**) are differentiated from the rest of the vehicle (represented by the resistance **R3,** being the sum of many parallel resistances). The fuel cell system **10** is configured to be monitored by a ground fault detection system **200,** which in the shown example is at least partly embodied by an isolation resistance monitor device **210.**

Generally, determining a faulty ground connection is achieved by collecting the grounding points of groups or single components so as to selectively connect directly to the chassis, and/or via a known resistance, and/or break a components ground to leave the component(s) floating (i.e. disconnected from the chassis).

In the shown example of FIG. 4, the resistance to a grounded component, such as the pump **11** or the radiator **12,** is shorted and isolation resistance measurement continues through the components ground strap.

Shorting across **R1** or **R2** should result in a drop in the measured isolation resistance proportional to the coolant conductivity which can then be estimated/calculated. If the isolation resistance is low and shorting across these resistances does not produce a significant drop then coolant conductivity is probably not the problem and replacing the coolant and ion exchange filters should not be necessary.

If **R3** has a significant resistance and shorting **R1** or **R2** do not produce symmetrical or correctly proportional responses then a grounding fault is indicated at the component **11, 12** producing the lower than expected drop.

The switch **S1** should be capable of surviving a significant current but it does not normally see significant current as conventional contactors do (since leakage currents are normally of mA magnitude or less). Optionally, if the switch **S1** is provided with a fuse that can be blown by potentially dangerous capacitive discharges then it may also be able to indicate these conditions since the fuse should blow and the ground fault detection system 200 will then start triggering a fault since no change will occur when it fails to short the resistances to ground.

The change in isolation resistance when the fuel cell stack **14** is connected can be used to calculate the isolation resistance of the fuel cell stack **14.** Alternatively the isolation resistance monitoring device **210** can be configured to measure the isolation resistance of the fuel cell stack **14** before it is connected.

By providing switchable grounding points in the coolant, much closer than is normally desired, and which are normally isolated but can be selectively shorted to ground **P** (or normally grounded and breakable) then a simulated fault can be created in the coolant system formed by conduits **20, 21** and the pump **11** and radiator **12.** The change in isolation resistance when the fault is made or broken gives an indicator as to the contribution that coolant electrical conductivity is making to the isolation resistance. In particular, if there is no or very little change in isolation resistance this indicates that a ground connection is missing. Optionally, a situation with no reaction may indicate that the switch **S1** is faulty

The resistance through the shorted fault path, i.e. over closed switch **S1,** can be calculated or estimated from the change in isolation resistance values.

Further, if the geometry of the coolant path between the fault ground point and the normal coolant ground point is known, then the coolant conductivity can be calculated or estimated from the fault path resistance. In many cases the shorting path cannot be a direct leak to ground (as this would trigger errors and shutdowns) so only part of the path is typically shorted. This division should then be planned to give a good result without causing problems and known so as to avoid creating unknowns.

In the specific example shown in FIG. 4, and especially where conductivity estimation is desired it is preferable to have onboard isolation measurement performed inside the fuel cell system **10** while it is disconnected from the other systems on the vehicle **1** as this helps to exclude uncertainty and external effects.

Here R3 is the collected resistances to ground via all other paths than the target path R1/R2. The IRM device normally sees (R1+R2)‖R3, such as:

$$\frac{1}{R_T} = \frac{1}{R_1+R_2} + \frac{1}{R_3}.$$

When S1 closes this reduces to R1‖R3, such as:

$$\frac{1}{R_{S1}} = \frac{1}{R_1} + \frac{1}{R_3},$$

thereby providing a system with a degree of freedom:

$$\frac{1}{R_T} - \frac{1}{R_{S1}} = \frac{1}{R_1+R_2} - \frac{1}{R_1}.$$

Where the division is known, say $R_1 = 2 \cdot R_2$, this becomes solvable for $R_1$, $R_2$ and R3:

$$\frac{1}{R_T} - \frac{1}{R_{S1}} = \frac{1}{(2+1)R_2} - \frac{1}{2R_2}.$$

$$R_2 = \frac{\left(\frac{1}{3} - \frac{1}{2}\right)}{\left(\frac{1}{R_T} - \frac{1}{R_{S1}}\right)}.$$

Where R2 is resistance through a non-conductive pipe with cross sectional area, A and length, L and is full of coolant with conductivity σ:

$$\sigma = \frac{L}{A \times R_2}.$$

The above highlights that the example shown in **FIG. 4** is a simplification since it shows only a single coolant leakage path.

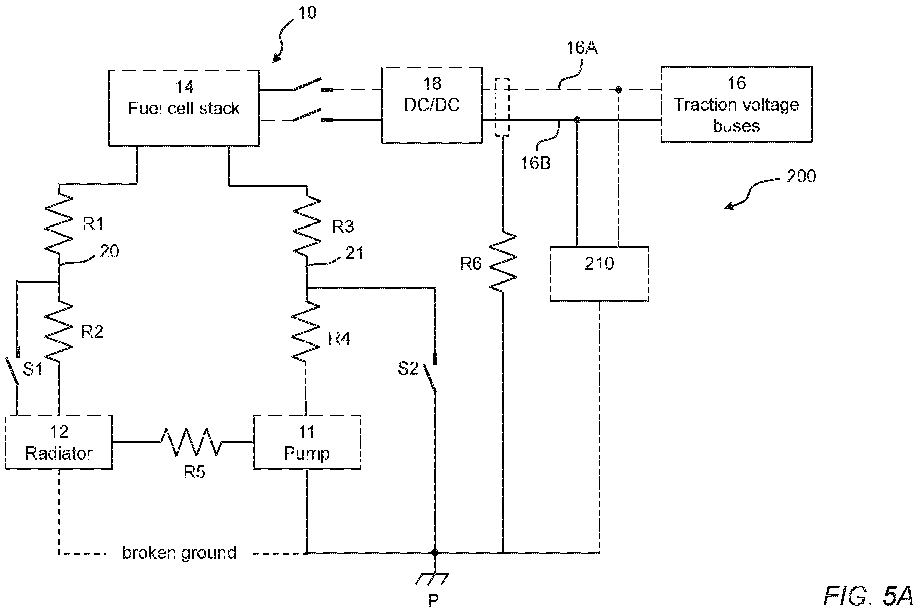

**FIG. 5A** shows a further example of a fuel cell system **10,** using two switches **S1, S2.** This provides two more states from the one additional switch **S1.** It also may allowing **R2** and **R4** to be a greater proportion of (**R1+R2**) and (**R3+R4**) since switching both switches **S1, S2** can be avoided where the total isolation resistance is prohibitively low. Yet further, the main advantage is that **R1+R2** can be differentiated from **R3+R4** which are at different temperatures.

First (**R3+R4**)‖**R6** can be bundled into a single resistance (**R3** in the example shown in **FIG. 4**) to allow the original solution for **R1, R2** to be performed in the same way. Then (**R1+R2**)‖**R6** can be analyzed in the same way but using switch **S2** instead.

This produces two different coolant conductivity values corresponding to the different temperatures of the inlet and outlet of the fuel cell stack **14.** This can be compared to the temperature dependence observed during warmup and other temperature fluctuations.

**R6** on its own can be calculated from the known (**R1+R2**) and (**R3+R4**).

Switching both switches **S1, S2** then produces a fourth state and over-defined system of equations allowing improvement of accuracy and reduction or quantification of uncertainty. If one of the switches **S1, S2** produces a disproportionately low impact then a broken or missing ground is indicated.

Calculation using **R1+R5** and/or **R3+R5** using known **R5** geometry and/or proportionality can recover affected measurements until the ground is repaired.

Coolant from a fuel cell system **10** is used as the example but the general concept could be extended to other devices or groups of devices.

Voltage can be measured at selected points rather than (or in combination with) analysis of the isolation resistance itself, in particular where a voltage division is created and/or modified. This has the potential for significantly higher accuracy and certainty compared to assessing changes in total vehicle isolation resistance measurement. This is due to the fact that projection from small changes in a large scale measurement is inherently inaccurate and the isolation resistance measurement is affected by corresponding change in capacitance).

This could be as simple as measuring/monitoring for voltage on or current flow to components like the pump **11** and/or the radiator **12** which should be grounded.

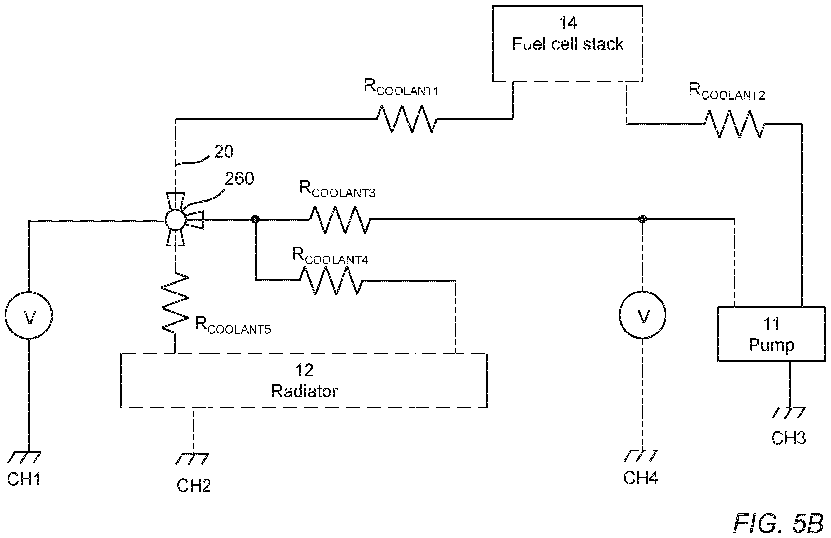

An example is shown in **FIG. 5B.** The voltage meter at right referencing **CH4** shows a simple voltage method according to the present disclosure where the system simply looks for unexpected voltage in what should be an electrically dead part of the system. However this is susceptible to disconnection or a missing ground as anything else.

At left referencing **CH1** another more tamper-resistant implementation is shown. In this case the voltage is measured slightly on the live side in the cooling system, potentially integrate in the three-way valve **260.** In this instance a low voltage implementation is shown where $R_{COOLANT5}$ is a known small fraction of $R_{COOLANT1}$ and is also much lower than the voltmeter impedance. This voltage divider should then deliver a reasonably constant fraction of the voltage between traction bus to ground; a fluctuating value controlled and monitored by the traction voltage bus isolation resistance monitoring device.

This is due to the constant measurement impedance having negligible influence on the $R_{COO-}$

LANT1:$R_{COOLANT5}$ which both share the same coolant conductivity dependance.

An electronic control unit can then check that a voltage or voltage fraction within acceptable range is being measured at another location (and hence chassis reference) and that this is synchronised with the isolation monitor values. This then provides a check not just that adjacent components are correctly grounded but that the electronic unit and also that the isolation monitor itself are all sharing the same ground reference.

Performing similar grounding checks by measuring the fluctuating voltage between the voltage bus and local chassis reference is also possible but needs higher voltage components and contributes much more leakage toward a lowered isolation resistance.

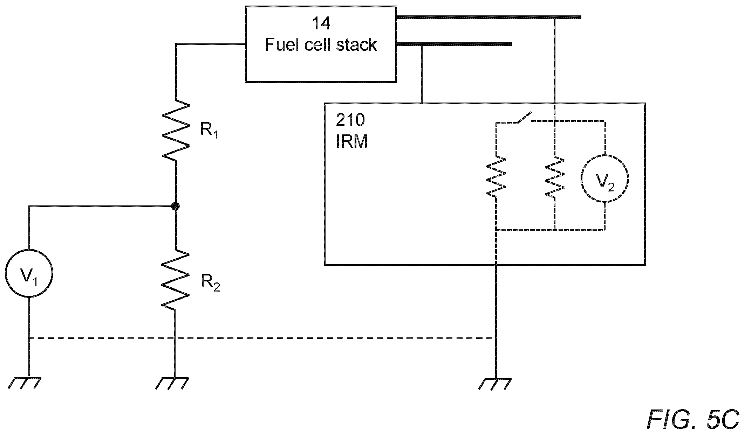

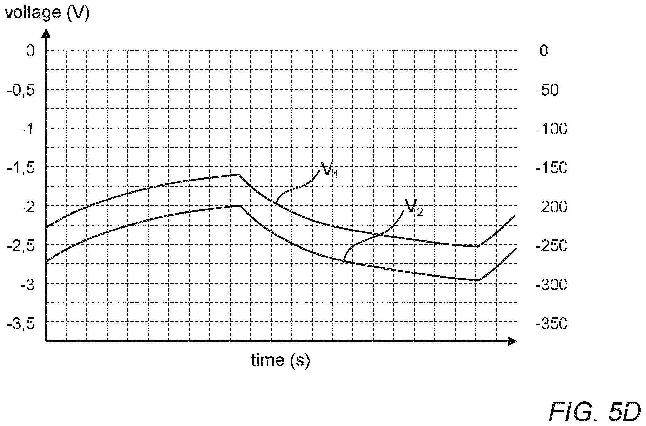

In **FIG. 5C** another example of a fuel cell system **10** is shown, also utilizing a simple voltage method. Voltage Vi represents a fraction of the total voltage, and the fluctuating behavior should correspond to the fluctuations of the voltage $V_2$. Measured values for the voltages $V_1$, $V_2$ are shown in **FIG. 5D**. This diagram shows real data relating to the voltage option. The low voltage Vi trace swinging between -1.7 and -2.5V is the voltage measured at left and is the direct result of the high voltage waveform swinging between - 200V and -300V and measured within the isolation resistance monitoring device **210** at right. If the isolation resistance monitoring device **210** loses ground continuity the Vi trace tends to collapse whereas if **R2** loses ground Vi will raise, most likely well out of range. Checking the synchronised wave forms can also make tampering with the safety system more difficult.

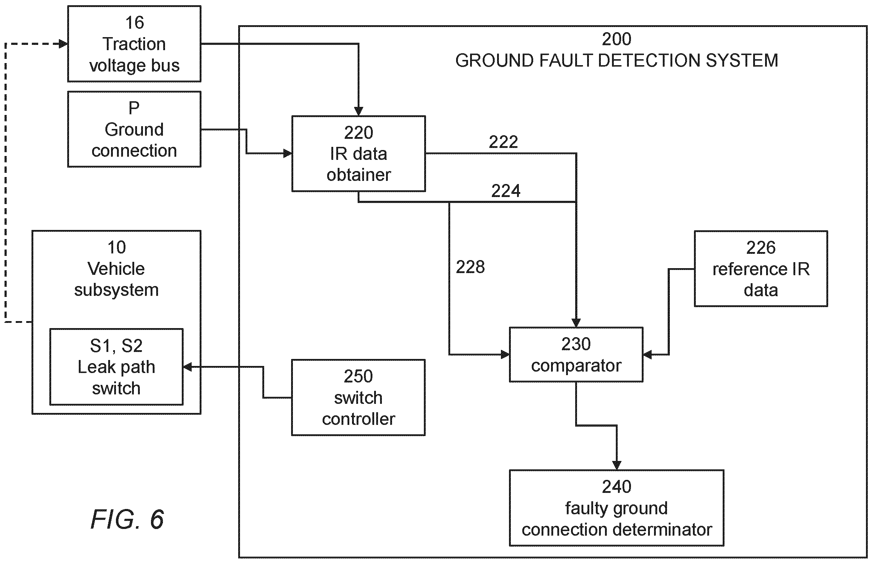

An example of a ground fault detection system **200** is shown in **FIG. 6.** The ground fault detection system **200** comprises an isolation resistance data obtainer **220,** e.g. in the form of an isolation resistance monitoring device **210,** configured to obtain first isolation resistance data **222** between a traction voltage pole **16A, 16B** of traction voltage buses **16** and a chassis **P** of a vehicle **1** when at least one vehicle subsystem, e.g. the fuel cell system **10,** is electrically disconnected from the traction voltage pole **16A, 16B.** When first isolation resistance data is obtained, the at least one vehicle subsystem **10** is electrically connected to the traction voltage pole **16A, 16B.**

The isolation resistance data obtainer **220** is further configured to obtain second isolation resistance data **224** between a traction voltage pole **16A, 16B** of traction voltage buses **16** and a chassis **P** of a vehicle **1** when at least one vehicle subsystem, e.g. the fuel cell system **10,** is electrically connected to the traction voltage pole **16A, 16B.**

The ground fault detection system **200** further comprises a comparator **230** being configured to compare the second isolation resistance data **224** with the first isolation resistance data **222,** and a faulty ground connection determinator **240** being configured to determine a faulty ground connection of the at least one vehicle subsystem **10** based on the comparison of the second isolation resistance data **224** with the first isolation resistance data **222.**

So far, the ground fault detection system **200** provide the same functionality as described with reference to the example shown in **FIG. 3.** The total isolation resistance $R_{tot}$ will likely decrease when the vehicle subsystem **10,** i.e. the fuel cell system **10,** is electrically connected to the traction voltage buses **16.** When there is no faulty ground connection of the vehicle subsystem **10** the second isolation resistance data **224** will be significantly lower than the first isolation resistance data **222.** However, if a faulty ground connection does exist, as in the example shown in **FIG. 2,** the second isolation resistance data **224** will be higher although still lower than the first isolation resistance data **222.** Hence, by knowing an expected difference or ratio between the first and second isolation resistance data **222, 224** when all ground connections are perfect, it is possible to identify a missing or faulty ground connection simply based on a comparison between the first and second isolation resistance data **222, 224.**

For this purpose the ground fault detection system **200** comprises, or is configured to obtain, reference isolation resistance data **226.** The comparator **230** is configured to obtain the reference isolation resistance data **226** and use this when comparing the first and second isolation resistance data **222, 224.** The reference isolation resistance data **226** may be predetermined or estimated, representing one or more threshold values, intervals, or ratios. For example, if the reference isolation resistance data is 3MΩ, a faulty ground connection may be determined by the faulty ground connection determinator **240** only when the second isolation resistance data **224** is above this value. In another example, the reference isolation resistance data may be a factor of 0,5. Hence a faulty ground connection may be determined by the faulty ground connection determinator **240** only when the second isolation resistance data **224** is above 50% of the first isolation resistance data **224.** The comparator **230** may be further configured to obtain, e.g. by determining, an isolation resistance difference between the first isolation resistance data **222** and the second isolation resistance data **224,** and using reference isolation resistance data **226** in the form of a pre-determined reference difference when comparing the obtained isolation resistance difference with the pre-determined reference difference **226.**

Alternatively, the reference isolation resistance data **226** may be obtained as a predetermined reference difference interval.

As mentioned earlier, the faulty ground connection determinator **240** may be configured to determine a faulty ground connection of the at least one vehicle subsystem **10** when the second isolation resistance data **224** is less than the first isolation resistance data **222.**

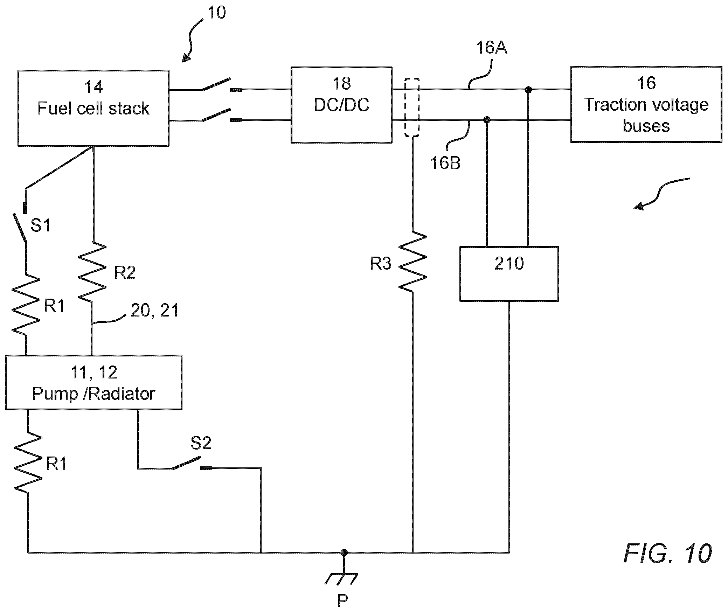

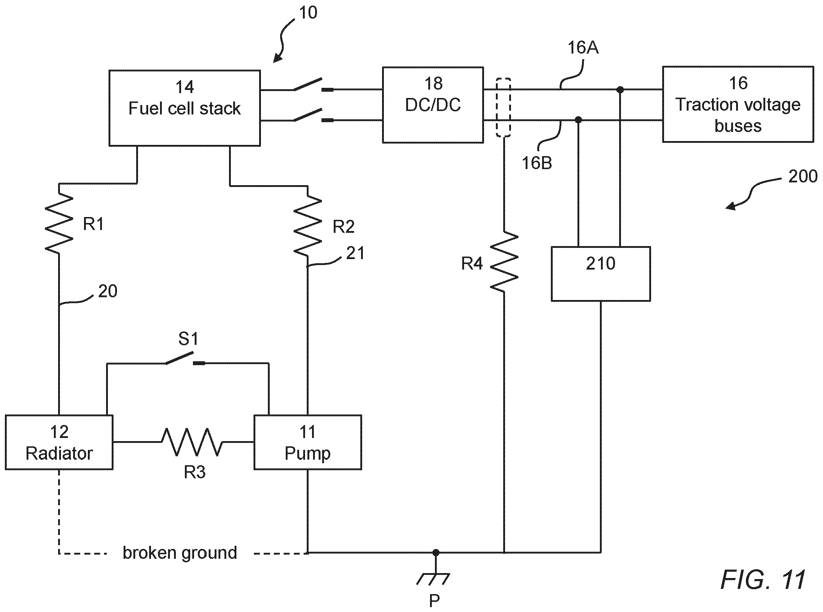

As shown in **FIG. 6** the ground fault detection system **200** comprises a switch controller **250.** The switch controller **250** is configured to electrically short circuit a leakage path of the at least one vehicle subsystem **10** by controlling one or more switches **S1, S2.** When at least one of said switches **S1, S2** is closed one or more leakage paths of the vehicle subsystem **10** is electrically short circuited. For example, in some simple cases the switch may be providing an alternative path to ground (see **FIG. 10**) or bridging two components (see **FIG. 11**) which should both be grounded in order to check that no response occurs In this mode, the isolation resistance data obtainer **220** is configured to obtain third isolation resistance data **228** between the traction voltage pole **16** and the chassis **P.**

The third isolation resistance data **228** is used by the comparator **230,** which is further configured to compare the third isolation resistance data **228** with the second isolation resistance data **224.** Based on this comparison, the faulty ground connection determinator **240** is configured to determine a faulty ground connection of the at least one vehicle subsystem **10** based on the comparison of the third isolation resistance data **228** with the second isolation resistance data **224.**

Since the electrical conductivity of the coolant flowing in the conduits **20, 21** may be temperature dependent, the isolation resistance data obtainer **220** may be configured to obtain second and/or third isolation resistance data **224, 228** for each one of a plurality of temperatures of the at least one vehicle subsystem **10.** The comparator **230** may consequently be configured to compare each one of the second and/or third isolation resistance data **224, 228** with the first isolation resistance data **222** in order for the faulty ground connection determinator **240** to determine if a faulty ground connection is present. Also the reference isolation resistance data may take temperature into account in determining its value. The reference data may also be from specification, it may be from a model such as an aging model, or it may incorporate real vehicle data such as measurements taken during or shortly after production or when the systems are in a known good state.

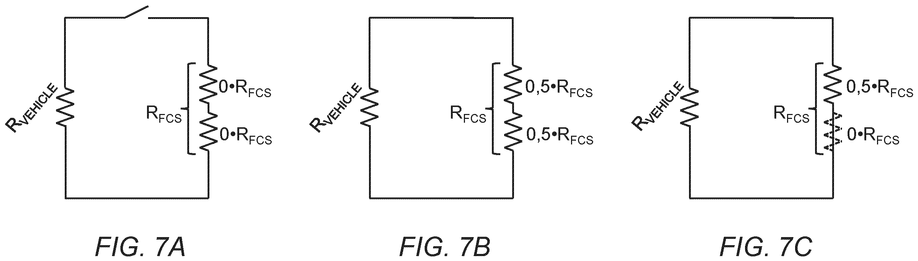

**FIGS. 7A-C** schematically show electrical circuit diagrams during a method for detecting a ground fault, e.g. using a ground fault detection system **200** as described above. In a first state, shown in **FIG. 7A,** the fuel cell stack **10** is electrically disconnected from the traction voltage buses **16,** thereby not contributing with any isolation resistance. By measuring the total isolation resistance $R_{tot}$, it follows that $R_{VEHICLE} = R_{tot}$. For the following, it is assumed that $R_{VEHICLE} = R_{tot} = 6M\Omega$.

As a next step, and as is shown in **FIG. 7B,** the fuel cell stack **10** is electrically connected to the traction voltage bus **16.** It is assumed that when again measuring the total isolation resistance, it has dropped to $3M\Omega$.

Since $\dfrac{1}{R_{tot}} = \dfrac{1}{R_{VEHICLE}} + \dfrac{1}{R_{FCS}}$ , it follows that $R_{FCS}$ $= 6M\Omega$.

Although it is possible to determine if there is a faulty ground connection or not by comparing the values of $R_{tot}$ before and after the fuel cell stack **14** has been electrically connected, as is shown in **FIG. 7C** a further measurement of the total isolation resistance is made after half of the resistance of the fuel cell stack **14** has been shorted. Hence, the new value of $R_{FCS}$ should be $3M\Omega$ which would result in an expected value of $R_{tot} = 2M\Omega$. IN particular, if the measured value of $R_{tot}$ is above $2M\Omega$ it would be an indication of a ground fault. Practically, $R_{FCS}$ also contains an isolation resistance component which does not depend on the coolant. If this component becomes a larger-than-expected contributor to the $R_{FCS}$ total then shorting the coolant will have a lower than expected effect in this model triggering the same fault but with a different root cause.

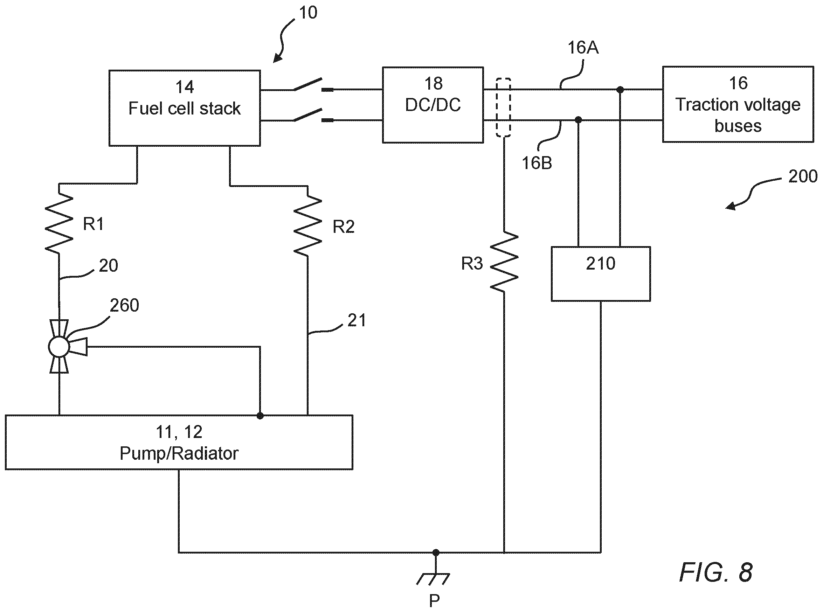

Further examples of fuel cell system **10,** comprising a ground fault detection system **200,** are shown in **FIGS. 8-11.**

Starting in **FIG. 8,** a multi-way valve (e.g. a mixing or blending valve) or flow blocking valve **260** is constructed so as to be able to selectively isolate the leakage of electrical current through a coolant line **20** to the chassis ground **P.**

The isolation resistance value can be raised in a safe way but generally not while the system is running since the flow of coolant must be shut off. A mixed example whereby the isolation resistance is intentionally raised via this method and then dropped via a short can improve accuracy.

This could be on the "fuel cell stack" side of **R1**, **R2,** it could split **R1** and **R2,** and could introduce another resistance on the bypass line. Ground fault detection algorithm remains solvable provided the proportionality is known. This likely means a valve body with some specific considerations and made from polymers although many existing devices would appear to meet these requirements.

Before and/or during start and after shutdown the **R1** leakage path can then be temporarily blocked, raising the isolation resistance measurement but without allowing voltages to raise on components. If **R1** is proportional to **R2** then the contribution of **R1**, **R2** can be separated from **R3** and as in prior examples the coolant conductivity can be calculated from **R1** and/or **R2** plus the hose geometry and when unusually low the need to check for potentially missing ground connections can be flagged.

This configuration more readily applies to the present disclosure without adding extra hardware such as switches. The method is basically comparing total or subsystem resistance before and after opening (or vice versa closing) the valve to obtain a total resistance with and without **R1;** from which **R1** can be calculated. The **R1** calculated will be wrong (high) if the relevant ground is missing since it will include the resistance of the resulting path to ground. Grounding checks are viable where the this **R1** value can be checked against a reference but otherwise rely on more information than is shown.

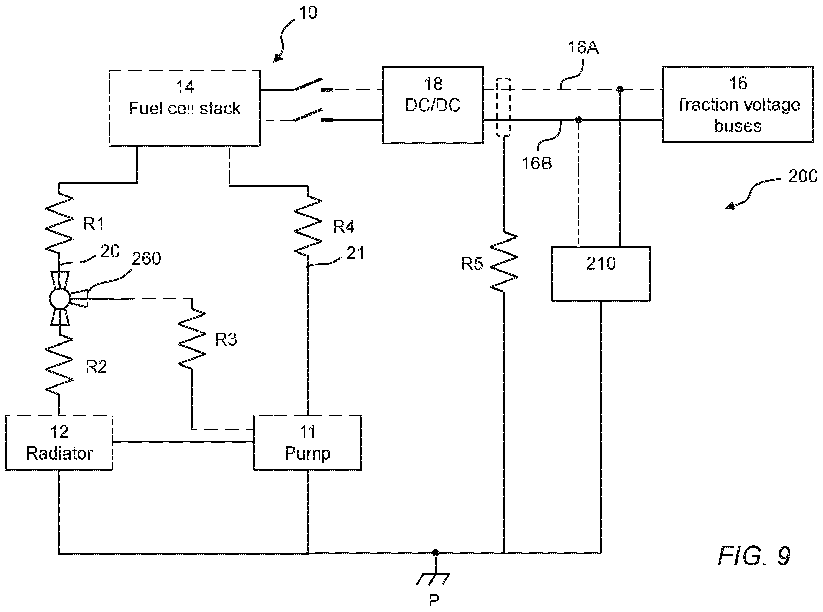

In **FIG. 9** the radiator bypass valve **260** never has to block flow to the fuel cell system **10** since it can instead block one of two ports. This valve **260** then operates as a switch between 3 states: **(R1+R2),** **(R1+R3),** (**R1 + R2‖R3**). In order to provide useful accuracy **R2** and **R3** may be as different as possible. However, in some cases it may be preferred to define **R2=R3**. Also it may be preferable that **R2** (and/or **R3**) are large or at least not small relative to **R1** in this instance. In most cases while running the system is in the (**R1+R2‖R3**) state, i.e. open to both paths. Unless isolation resistance monitoring switching synchronization is used to get rapid measurements or the temperatures are unusually homogenous then the system will only have one diversion case practically available to it. In most cases this will be when the system is using the radiator fan and can switch it off requiring/allowing the system to use full radiator flow or allowing the option with minimal temperature disturbance. In this case **R2** should be higher to maximize the difference between **R2** and **R2‖R3**. Alternatively the system may operate high flow to minimize delta and use bypass in freezing conditions. In this case **R3** should be higher. In general the more dominant case should have the higher resistance but this may be a tradeoff influenced by temperature delta and a number of practical considerations.

The first two cases/states referred to above only occur when flow is 100% to radiator **12** or 100% diverted respectively. Ideally then the system capacitance and valve **260** should be fast enough to be synchronized with the chassis voltage swing and such that the temperature ripple generated dissipates acceptably before reaching the fuel cell system **10**. Nonetheless temperature preferably needs to be considered in this approach and in an ideal situation **R2** and **R3** could be brought to similar temperature. However, as above most likely the full cooling diversion may benefit from being held long enough to allow a good isolation measurement, favoring or requiring conditions where this is practically feasible meaning the temperatures are similar. This favors startup and standstill or lowspeed conditions where the transients are slow and the radiator fan is in use.

In **FIG. 10** another example is shown. Considering switch **S1** and isolation resistance **R1** marked with dashes: In this example, **S1** without **R1** gives a simple solution but likely drops isolation resistance too low.

**R1** having a known fixed resistance has the problem of too many degrees of freedom (since **R1:R2** is not known **R2:R3** remains uncertain). Therefore **R1** is preferably a break in a parallel coolant resistance path such as an isolated 3-way valve shutting.

Instead considering resistance **R1** (marked in solid) with switch **S2:** where **R1** is added parallel to **S2** the safety is better but possibly too many unknowns result since the relationship **R1:R2** is hard to ensure.

In **FIG. 11** another example is shown. Here, the broken (or missing) ground on the radiator **12** can be detected since the isolation resistance measured should not normally change when **S1** makes or breaks. However, a shift is likely obtained due to the broken radiator ground connection indicated. This example may also works for pump ground missing. The **R3** path may include other parts or grounds, i.e. there might be a pump side and a radiator side **R3** etc. Basically the radiator and pump are the first grounding points on each path and all leakage current from each path should reach ground at these rather than passing through any path with resistance. Differentiating which ground is missing may not be possible in Fig 11 without other systems or information. If both radiator and pump grounds are missing **S1** will have little or no effect.

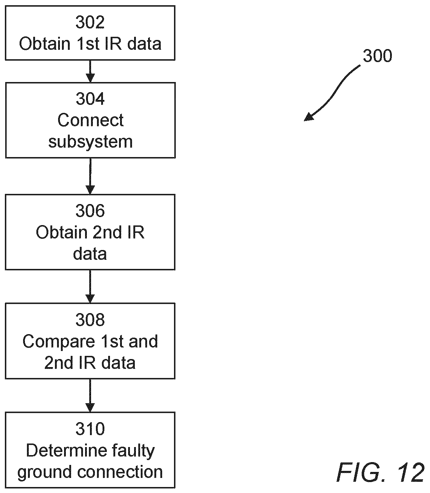

**FIG. 12** is a flow chart of a method **300** of ground fault detection according to an example. The computer-implemented method comprises obtaining **302,** by processing circuitry of a computer system, first isolation resistance data **222** between a traction voltage pole **16A, 16B** and a chassis **P** of a vehicle **1** when at least one vehicle subsystem **10** is electrically disconnected from the traction voltage pole **16A, 16B**. The method further comprises electrically connecting **304,** by the processing circuitry, the at least one vehicle subsystem **10** to the traction voltage pole **16A, 16B,** and obtaining **306,** by the processing circuitry, second isolation resistance data **224** between the traction voltage pole **16A, 16B** and the chassis **P** when the at least one vehicle subsystem **10** is electrically connected to the traction voltage pole **16A, 16B.**

The method **300** further comprises comparing **308,** by the processing circuitry, the second isolation resistance data **224** with the first isolation resistance data **222;** and determining **310,** by the processing circuitry, a faulty ground connection of the at least one vehicle subsystem **10** based on the comparison of the second isolation resistance data **224** with the first isolation resistance data **222.**

**FIG. 13** is a schematic diagram of a computer system **400** for implementing examples disclosed herein. The computer system **400** is adapted to execute instructions from a computer-readable medium to perform these and/or any of the functions or processing described herein. The computer system **400** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **400** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 400 may comprise at least one computing device or electronic device capable of including firmware, hardware, and/or executing software instructions to implement the functionality described herein. The computer system 400 may include processing circuitry 402 (e.g., processing circuitry including one or more processor devices or control units), a memory 404, and a system bus 406. The computer system 400 may include at least one computing device having the processing circuitry 402. The system bus 406 provides an interface for system components including, but not limited to, the memory 404 and the processing circuitry 402. The processing circuitry 402 may include any number of hardware components for conducting data or signal processing or for executing computer code stored in memory 404. The processing circuitry 402 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 402 may further include computer executable code that controls operation of the programmable device.

The system bus 406 may be any of several types of bus structures that may further interconnect to a memory bus (with or without a memory controller), a peripheral bus, and/or a local bus using any of a variety of bus architectures. The memory 404 may be one or more devices for storing data and/or computer code for completing or facilitating methods described herein. The memory 404 may include database components, object code components, script components, or other types of information structure for supporting the various activities herein. Any distributed or local memory device may be utilized with the systems and methods of this description. The memory 404 may be communicably connected to the processing circuitry 402 (e.g., via a circuit or any other wired, wireless, or network connection) and may include computer code for executing one or more processes described herein. The memory 404 may include non-volatile memory 408 (e.g., read-only memory (ROM), erasable programmable read-only memory (EPROM), electrically erasable programmable read-only memory (EEPROM), etc.), and volatile memory 410 (e.g., random-access memory (RAM)), or any other medium which can be used to carry or store desired program code in the form of machine-executable instructions or data structures and which can be accessed by a computer or other machine with processing circuitry 402. A basic input/output system (BIOS) 412 may be stored in the non-volatile memory 408 and can include the basic routines that help to transfer information between elements within the computer system 400.

The computer system 400 may further include or be coupled to a non-transitory computer-readable storage medium such as the storage device 414, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 414 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 414 and/or in the volatile memory 410, which may include an operating system 416 and/or one or more program modules 418. All or a portion of the examples disclosed herein may be implemented as a computer program 420 stored on a transitory or non-transitory computer-usable or computer-readable storage medium (e.g., single medium or multiple media), such as the storage device 414, which includes complex programming instructions (e.g., complex computer-readable program code) to cause the processing circuitry 402 to carry out actions described herein. Thus, the computer-readable program code of the computer program 420 can comprise software instructions for implementing the functionality of the examples described herein when executed by the processing circuitry 402. In some examples, the storage device 414 may be a computer program product (e.g., readable storage medium) storing the computer program 420 thereon, where at least a portion of a computer program 420 may be loadable (e.g., into a processor) for implementing the functionality of the examples described herein when executed by the processing circuitry 402. The processing circuitry 402 may serve as a controller or control system for the computer system 400 that is to implement the functionality described herein.

The computer system 400 may include an input device interface 422 configured to receive input and selections to be communicated to the computer system 400 when executing instructions, such as from a keyboard, mouse, touch-sensitive surface, etc. Such input devices may be connected to the processing circuitry 402

through the input device interface **422** coupled to the system bus **406** but can be connected through other interfaces, such as a parallel port, an Institute of Electrical and Electronic Engineers (IEEE) 1394 serial port, a Universal Serial Bus (USB) port, an IR interface, and the like. The computer system **400** may include an output device interface **424** configured to forward output, such as to a display, a video display unit (e.g., a liquid crystal display (LCD) or a cathode ray tube (CRT)). The computer system **400** may include a communications interface **426** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

**Example 1:** A computer system comprising processing circuitry configured to: obtain first isolation resistance data (222) between a traction voltage pole (16A, 16B) and a chassis (P) of a vehicle (1) when at least one vehicle subsystem (10) is electrically disconnected from the traction voltage pole (16A, 16B); electrically connect the at least one vehicle subsystem (10) to the traction voltage pole (16A, 16B); obtain second isolation resistance data (224) between the traction voltage pole (16A, 16B) and the chassis (P) when the at least one vehicle subsystem (10) is electrically connected to the traction voltage pole (16A, 16B); compare the second isolation resistance data (224) with the first isolation resistance data (222); and determine a faulty ground connection of the at least one vehicle subsystem (10) based on the comparison of the second isolation resistance data (224) with the first isolation resistance data (222).

**Example 2:** The computer system of Example 1, wherein the processing circuitry is further configured to: obtain an isolation resistance difference between the first isolation resistance data (222) and the second isolation resistance data (224); obtain a pre-determined reference difference; and compare the obtained isolation resistance difference with the pre-determined reference difference.

**Example 3:** The computer system of Example 2, wherein the processing circuitry is further configured to: obtain the pre-determined reference difference as a predetermined reference difference interval.

**Example 4:** The computer system of any of Examples 1 to 3, wherein the processing circuitry is further configured to: determine a faulty ground connection of the at least one vehicle subsystem (10) when the second isolation resistance data (224) is less than the first isolation resistance data (222).

**Example 5:** The computer system of any of Examples 1-4, wherein the processing circuitry is further configured to: electrically short circuit a leakage path of the at least one vehicle subsystem (10); obtain third isolation resistance data (228) between the traction voltage pole (16A, 16B) and the chassis (P) when the leakage path of at least one vehicle subsystem (10) is electrically short circuited; compare the third isolation resistance data (228) with the second isolation resistance data (224); and determine a faulty ground connection of the at least one vehicle subsystem (10) based on the comparison of the third isolation resistance data (228) with the second isolation resistance data (224).

**Example 6:** The computer system of any of Examples 1-5, wherein the processing circuitry is further configured to: obtain second isolation resistance data (224) for each one of a plurality of temperatures of the at least one vehicle subsystem (10); and compare each one of the second isolation resistance data (224) with the first isolation resistance data (222).

**Example 7:** The computer system of Example 1, wherein the processing circuitry is further configured to: obtain an isolation resistance difference between the first isolation resistance data (222) and the second isolation resistance data (224); obtain a pre-determined reference difference interval; and compare the obtained isolation resistance difference with the pre-determined reference difference interval; electrically short circuit a leakage path of the at least one vehicle subsystem (10); obtain third isolation resistance data (228) between the traction voltage pole (16A, 16B) and the chassis (P) for a plurality of temperatures when the leakage path of at least one vehicle subsystem (10) is electrically short circuited; obtain an isolation resistance difference between each one of the third isolation resistance data (228) and the second isolation resistance data (224); obtain a pre-determined reference difference interval; compare the obtained isolation resistance difference with the pre-determined reference difference interval; and determine a faulty ground connection of the at least one vehicle subsystem (10) based on the comparison of the third isolation resistance data (228) with the second isolation resistance data (224) and/or based on the comparison of the second isolation resistance data (224) with the first isolation resistance data (222).

**Example 8:** A vehicle comprising the computer system of any of Examples 1-7.

**Example 9:** The vehicle of Example 8, further comprising at least one fuel cell system (10) forming the vehicle subsystem (10).

**Example 10:** The vehicle of Example 9, wherein the at least one fuel cell system (10) comprises at least one coolant conduit (20, 21) connected to a radiator (12), and wherein the coolant forms a leakage path.

**Example 11:** The vehicle of Example 9 or 10, further comprising a switch (S1, S2) configured to short circuit the leakage path.

**Example 12:** A computer-implemented method, comprising: obtaining, by processing circuitry of a computer system, first isolation resistance data (222) between a traction voltage pole (16A, 16B) and a chassis (P) of a vehicle (1) when at least one vehicle subsystem (10) is electrically disconnected from the traction voltage pole (16A, 16B); electrically connecting, by the processing circuitry, the at least one vehicle subsystem (10) to the traction voltage pole (16A, 16B); obtaining, by the processing circuitry, second isolation resistance data (224) between the traction voltage pole (16A, 16B) and the chassis (P) when the at least one vehicle subsystem (10) is electrically connected to the traction voltage pole (16A, 16B); comparing, by the processing circuitry, the second isolation resistance data (224) with the first isolation resistance data (222); and determining, by the processing circuitry, a faulty ground connection of the at least one vehicle subsystem (10) based on the comparison of the second isolation resistance data (224) with the first isolation resistance data (222).

**Example 13:** The method of Example 12, further comprising: obtaining, by the processing circuitry, an isolation resistance difference between the first isolation resistance data (222) and the second isolation resistance data (224); obtaining, by the processing circuitry, a pre-determined reference difference; and comparing, by the processing circuitry, the obtained isolation resistance difference with the pre-determined reference difference.

**Example 14:** The method of Example 13, further comprising: obtaining, by the processing circuitry, the pre-determined reference difference as a predetermined reference difference interval.

**Example 15:** The method of any of Examples 12-14, further comprising: determining, by the processing circuitry, a faulty ground connection of the at least one vehicle subsystem (10) when the second isolation resistance data (224) is greater the first isolation resistance data (222).

**Example 16:** The method of any of Examples 12-15, further comprising: electrically short circuiting, by the processing circuitry, a leakage path of the at least one vehicle subsystem (10); obtaining, by the processing circuitry, third isolation resistance data (228) between the traction voltage pole (16A, 16B) and the chassis (P) when the leakage path of at least one vehicle subsystem (10) is electrically short circuited; comparing, by the processing circuitry, the third isolation resistance data (228) with the second isolation resistance data (224); and determining, by the processing circuitry, a faulty ground connection of the at least one vehicle subsystem (10) based on the comparison of the third isolation resistance data (228) with the second isolation resistance data (224).

**Example 17:** The method of any of Examples 12-16, further comprising: obtaining, by the processing circuitry, second isolation resistance data (224) for each one of a plurality of temperatures of the at least one vehicle subsystem (10); and comparing, by the processing circuitry, each one of the second isolation resistance data (224) with the first isolation resistance data (222).

**Example 18:** The method of Example 16 and 17, further comprising: obtaining, by the processing circuitry, third isolation resistance data (228) for each one of a plurality of temperatures of the at least one vehicle subsystem (10); and comparing, by the processing circuitry, each one of the third isolation resistance data (228) with the second isolation resistance data (224).

**Example 19:** A computer program product comprising program code for performing, when executed by the processing circuitry, the method of any of Examples 12-18.

**Example 20:** A non-transitory computer-readable storage medium comprising instructions, which when executed by the processing circuitry, cause the processing circuitry to perform the method of any of Examples 12-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system comprising processing circuitry configured to:

   obtain first isolation resistance data (222) between a traction voltage pole (16A, 16B) and a chassis (P) of a vehicle (1) when at least one vehicle subsystem (10) is electrically disconnected from the traction voltage pole (16A, 16B); electrically connect the at least one vehicle subsystem (10) to the traction voltage pole (16A, 16B); obtain second isolation resistance data (224) between the traction voltage pole (16A, 16B) and the chassis (P) when the at least one vehicle subsystem (10) is electrically connected to the traction voltage pole (16A, 16B); compare the second isolation resistance data (224) with the first isolation resistance data (222); and determine a faulty ground connection of the at least one vehicle subsystem (10) based on the comparison of the second isolation resistance data (224) with the first isolation resistance data (222).

2. The computer system of claim 1, wherein the processing circuitry is further configured to:

   obtain an isolation resistance difference between the first isolation resistance data (222) and the second isolation resistance data (224); obtain a pre-determined reference difference; and compare the obtained isolation resistance difference with the pre-determined reference difference.

3. The computer system of claim 2, wherein the processing circuitry is further configured to:
   obtain the pre-determined reference difference as a predetermined reference difference interval.

4. The computer system of any of claims 1 to 3, wherein the processing circuitry is further configured to:
   determine a faulty ground connection of the at least one vehicle subsystem (10) when the second isolation resistance data (224) is less than the first isolation resistance data (222).

5. The computer system of any of claims 1-4, wherein the processing circuitry is further configured to:

   electrically short circuit a leakage path of the at least one vehicle subsystem (10); obtain third isolation resistance data (228) between the traction voltage pole (16A, 16B) and the chassis (P) when the leakage path of at least one vehicle subsystem (10) is electrically short circuited; compare the third isolation resistance data (228) with the second isolation resistance data (224); and determine a faulty ground connection of the at least one vehicle subsystem (10) based on the comparison of the third isolation resistance data (228) with the second isolation resistance data (224).

6. The computer system of any of claims 1-5, wherein the processing circuitry is further configured to:

   obtain second isolation resistance data (224) for each one of a plurality of temperatures of the at least one vehicle subsystem (10); and compare each one of the second isolation resistance data (224) with the first isolation resistance data (222).

7. The computer system of claim 1, wherein the processing circuitry is further configured to:

   obtain an isolation resistance difference between the first isolation resistance data (222) and the second isolation resistance data (224); obtain a pre-determined reference difference interval; and compare the obtained isolation resistance difference with the pre-determined reference difference interval; electrically short circuit a leakage path of the at least one vehicle subsystem (10); obtain third isolation resistance data (228) between the traction voltage pole (16A, 16B) and the chassis (P) for a plurality of temperatures when the leakage path of at least one vehicle subsystem (10) is electrically short circuited;

obtain an isolation resistance difference between each one of the third isolation resistance data (228) and the second isolation resistance data (224);

obtain a pre-determined reference difference interval;

compare the obtained isolation resistance difference with the pre-determined reference difference interval; and

determine a faulty ground connection of the at least one vehicle subsystem (10) based on the comparison of the third isolation resistance data (228) with the second isolation resistance data (224) and/or based on the comparison of the second isolation resistance data (224) with the first isolation resistance data (222).

8. A vehicle comprising the computer system of any of claims 1-7.

9. The vehicle of claim 8, further comprising at least one fuel cell system and/or an immersion cooled battery system (10) forming the vehicle subsystem (10).

10. The vehicle of claim 9, wherein the at least one fuel cell system and/or immersion cooled battery system (10) comprises at least one coolant conduit (20, 21) connected to a radiator (12), and wherein the coolant forms a leakage path.

11. The vehicle of claim 9 or 10, further comprising a switch (S1, S2) configured to short circuit the leakage path.

12. A computer-implemented method, comprising:

obtaining, by processing circuitry of a computer system, first isolation resistance data (222) between a traction voltage pole (16A, 16B) and a chassis (P) of a vehicle (1) when at least one vehicle subsystem (10) is electrically disconnected from the traction voltage pole (16A, 16B);

electrically connecting, by the processing circuitry, the at least one vehicle subsystem (10) to the traction voltage pole (16A, 16B);

obtaining, by the processing circuitry, second isolation resistance data (224) between the traction voltage pole (16A, 16B) and the chassis (P) when the at least one vehicle subsystem (10) is electrically connected to the traction voltage pole (16A, 16B);

comparing, by the processing circuitry, the second isolation resistance data (224) with the first isolation resistance data (222); and

determining, by the processing circuitry, a faulty ground connection of the at least one vehicle subsystem (10) based on the comparison of the second isolation resistance data (224) with the first isolation resistance data (222).

13. The method of claim 12, further comprising:

electrically short circuiting, by the processing circuitry, a leakage path of the at least one vehicle subsystem (10);

obtaining, by the processing circuitry, third isolation resistance data (228) between the traction voltage pole (16A, 16B) and the chassis (P) when the leakage path of at least one vehicle subsystem (10) is electrically short circuited;

comparing, by the processing circuitry, the third isolation resistance data (228) with the second isolation resistance data (224); and

determining, by the processing circuitry, a faulty ground connection of the at least one vehicle subsystem (10) based on the comparison of the third isolation resistance data (228) with the second isolation resistance data (224).

14. A computer program product comprising program code for performing, when executed by the processing circuitry, the method of any of claims 12-13.

15. A non-transitory computer-readable storage medium comprising instructions, which when executed by the processing circuitry, cause the processing circuitry to perform the method of any of claims 12-13.

FIG. 1

FIG. 2

FIG. 3

**200**
**GROUND FAULT DETECTION SYSTEM**

- 16 Traction voltage buses
- P Ground connection
- 10 Vehicle subsystem
- 220 IR data obtainer
- 222
- 224
- 230 comparator
- 240 faulty ground connection determinator

EP 4 707 823 A1

FIG. 4

EP 4 707 823 A1

FIG. 5A

EP 4 707 823 A1

*FIG. 5B*

FIG. 5C

FIG. 5D

EP 4 707 823 A1

FIG. 6

FIG. 7A

FIG. 7B

FIG. 7C

FIG. 8

EP 4 707 823 A1

EP 4 707 823 A1

Traction voltage buses — 16

200

16A

16B

210

18 DC/DC

R5

P

10

R4 — 21

11 Pump

R3

14 Fuel cell stack

R1

20  260

R2

12 Radiator

FIG. 9

29

FIG. 10

EP 4 707 823 A1

FIG. 11

EP 4 707 823 A1

```
┌─────────────────────┐
│        302          │
│  Obtain 1st IR data │
└─────────────────────┘
           │
           ▼
┌─────────────────────┐
│        304          │
│     Connect         │
│    subsystem        │
└─────────────────────┘
           │
           ▼
┌─────────────────────┐
│        306          │
│   Obtain 2nd IR     │
│       data          │
└─────────────────────┘
           │
           ▼
┌─────────────────────┐
│        308          │
│  Compare 1st and    │
│    2nd IR data      │
└─────────────────────┘
           │
           ▼
┌─────────────────────┐
│        310          │
│  Determine faulty   │
│ ground connection   │
└─────────────────────┘
```

300

*FIG. 12*

FIG. 13

Europäisches
Patentamt

European
Patent Office

Office européen
des brevets

# EUROPEAN SEARCH REPORT

**Application Number**

EP 24 19 8454

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2022 102499 A1 (WEBASTO SE [DE]) 3 August 2023 (2023-08-03) | 1,8,12, 14,15 | INV. G01R27/02 G01R31/52 |
| Y | * the whole document * | 9,10 | |
| A | | 2-7,11, 13 | |
| | ----- | | |
| Y | US 2014/266223 A1 (FOLEY ROBERT S [US]) 18 September 2014 (2014-09-18) * paragraph [0019] - paragraph [0020]; figures 1-2 * | 9,10 | |
| | ----- | | |
| Y | US 2022/221500 A1 (PARK HYO JIN [KR] ET AL) 14 July 2022 (2022-07-14) * paragraph [0044] - paragraph [0048]; figure 1 * | 9,10 | |
| | ----- | | |

**TECHNICAL FIELDS SEARCHED (IPC)**

G01R

The present search report has been drawn up for all claims

| Place of search | Date of completion of the search | Examiner |
|---|---|---|
| Munich | 19 February 2025 | Mazagão Guerreiro, R |

EPO FORM 1503 03.82 (P04C01)

**EP 4 707 823 A1**

## ANNEX TO THE EUROPEAN SEARCH REPORT
## ON EUROPEAN PATENT APPLICATION NO.

EP 24 19 8454

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2025

| Patent document cited in search report | Publication date | Patent family member(s) | Publication date |
|---|---|---|---|
| DE 102022102499 A1 | 03-08-2023 | DE 102022102499 A1<br>WO 2023148328 A1 | 03-08-2023<br>10-08-2023 |
| US 2014266223 A1 | 18-09-2014 | CN 104051759 A<br>DE 102014103117 A1<br>US 2014266223 A1 | 17-09-2014<br>18-09-2014<br>18-09-2014 |
| US 2022221500 A1 | 14-07-2022 | CN 114755496 A<br>KR 20220101298 A<br>US 2022221500 A1 | 15-07-2022<br>19-07-2022<br>14-07-2022 |

EPO FORM P0459

For more details about this annex : see Official Journal of the European Patent Office, No. 12/82